# EUROPÄISCHE PATENTSCHRIFT

(11) **EP 3 273 204 B1**
(45) Veröffentlichungstag und Bekanntmachung des Hinweises auf die Patenterteilung: **19.06.2019**
(21) Anmeldenummer: 17001175.3
(22) Anmeldetag: 10.07.2017
(51) Int. Cl.: G01D 9/00, G01D 11/24, H05K 1/14, H05K 1/18, H05K 5/00

(54) **DATENLOGGER UND VERWENDUNG VON ZWEI METALLISCHEN WANDBEREICHEN EINES GEHÄUSES EINES DATENLOGGERS**
DATA LOGGER AND USE OF TWO METALLIC WALL AREAS OF A HOUSING OF A DATA LOGGER
ENREGISTREUR DE DONNÉES ET UTILISATION DE DEUX ZONES DE PAROI MÉTALLIQUES D'UN BOÎTIER D'UN ENREGISTREUR DE DONNÉES

(30) Priorität: 15.07.2016 DE 102016008518
(43) Veröffentlichungstag der Anmeldung: 24.01.2018
(73) Patentinhaber: Testo SE & Co. KGaA, 79853 Lenzkirch (DE)
(72) Erfinder: Ketterer, Klaus, 79822 Titisee-Neustadt (DE)
(74) Vertreter: Börjes-Pestalozza, Henrich

(56) Entgegenhaltungen:
- EP-A2- 2 567 198
- EP-A2- 2 884 826
- DE-A1- 4 312 862
- DE-C1- 19 610 167
- DE-T5-112013 001 898

## Beschreibung

Die Erfindung betrifft einen Datenlogger, mit wenigstens einen Messsensor, einer Sensorsignalverarbeitungseinrichtung, die zu einer Verarbeitung eines Sensorsignals des wenigstens einen Messsensors eingerichtet ist, wobei an der Sensorsignalverarbeitungseinrichtung ein Datenanschluss mit einem ersten Pol und einem zweiten Pol ausgebildet ist, und einem Gehäuse, in welchem die Sensorsignalverarbeitungseinrichtung angeordnet sind, wobei das Gehäuse nach außen dicht ausgebildet ist.

Derartige Datenlogger sind bekannt und dienen der Aufzeichnung einer Serie von Messwerten, die zu vorbestimmten Zeitpunkten gemessen wurden. Beispielsweise kann die Aufzeichnung von Messwerten in klimatisch ungünstigen oder vorzugsweise rauen oder Umgebungsbedingungen erfolgen. Hier sind häufig Temperaturbereiche von -50°C bis +140°C und/oder 100% Luftfeuchtigkeit und/oder Überdrücke von 5 bar absolut oder mehr abzudecken.

Dies stellt besondere Anforderungen an die Ausbildung eines Gehäuses. Zudem stellt ein Einsatz in Lebensmittelbranchen, beispielsweise zur Dokumentation oder Überwachung von Kühlketten, zusätzliche Anforderungen an das Gehäuse.

Es ist daher üblich geworden, die Gehäuse mit hoher Dichtigkeit herzustellen, beispielsweise aus Metall. Zum Programmieren und Auslesen der Daten ist jedoch oft die Übermittlung in das Gehäuse erforderlich. Wegen der Metallgehäuse bereitet eine Funkübermittlung jedoch Schwierigkeiten. Eine Funkübermittlung kann auch problematisch sein, da der Energieverbrauch für den Betrieb zu hoch wäre.

Nachfolgend werden einige vorbekannte Datenlogger und sonstige Vorrichtungen aufgeführt.

Aus der DE 43 12 862 A1 ist eine Vorrichtung zum Messen der Dicke von in Bewegung befindlichen Folien bekannt, wobei die Vorrichtung als drehbaren Sensor ein kapazitives Element aufweist, das eine in Bewegung befindliche Folienbahn während des Gebrauchs berührt.

Aus der DE 196 10 167 C1 ist ein Messgerät zur Ermittlung von Zustandsgrößen eines flüssigen Mediums bekannt. Das Messgerät kann dabei komplett in ein flüssiges Medium eingetaucht werden, wobei die Vorrichtung über elektrische Leitungen mit einer Energieversorgung und einer Datenverarbeitungseinrichtung während des Gebrauchs verbunden ist.

Aus der DE 11 2013 001 898 T5 ist ein Gehäuse zum Einkapseln einer Stromversorgung für eine Sonde beschrieben.

Aus der EP 2 567 198 A0 ist eine Sonde und ein Verfahren zur Herstellung einer Sonde bekannt, wobei dabei vorgesehen ist, dass eine Datenübertragung anhand einer kabelgebundenen Kabelübertragungsleitung, die an entsprechende Anschlussstellen anschließbar ist, erfolgt.

Aus der EP 2 884 826 A2 ist ein elektronisches Gerät bekannt, welches dazu eingerichtet ist, um ein Füllharz bereitzustellen, wobei die Vorrichtung einen Näherungssensor aufweist, um leitfähige Objekte erkennen zu können.

Der Erfindung liegt die Aufgabe zugrunde, die Gebrauchseigenschaften eines Datenloggers zu verbessern.

Zur Lösung der Aufgabe sind erfindungsgemäß bei einem Datenlogger die Merkmale des Anspruchs 1 vorgesehen. Insbesondere wird somit zur Lösung der genannten Aufgabe bei einem Datenlogger der eingangs beschriebenen Art erfindungsgemäß vorgeschlagen, dass das Gehäuse einen ersten metallischen Wandbereich und einen zweiten metallischen Wandbereich aufweist, dass der erste metallische Wandbereiche und der zweite metallische Wandbereich voneinander elektrisch isoliert und jeweils von außen zugänglich sind und dass der erste Pol den ersten metallischen Wandbereiche von innen elektrisch kontaktiert und der zweite Pol den zweiten metallischen Wandbereiche elektrisch kontaktiert. Somit sind zusätzliche Anschlussmöglichkeiten wie Stecker oder Kabeldurchführungen verzichtbar. Das Gehäuse ist somit vereinfacht abdichtbar. Das aufnehmende Teil, in welchem der Datenlogger zwischen zwei Gebrauchsvorgängen gelagert wird, ist konstruktiv einfach ausbildbar. Hierdurch verbessern sich die Gebrauchseigenschaften beträchtlich. Die Erfindung bietet den weiteren Vorteil, dass eine drahtlose Datenverbindung, zum Beispiel per Funk, in das Innere des Datenloggers nicht erforderlich ist. Somit ist eine Leistungsaufnahme des Datenloggers reduzierbar, so dass beispielsweise eine Batterie des Datenloggers länger einsatzbereit bleiben kann.

Bei einer Ausgestaltung der Erfindung ist vorgesehen, dass ein Speicher zu einer elektronischen Hinterlegung des verarbeiteten Sensorsignals an die Sensorsignalverarbeitungseinrichtung angeschlossen ist. Somit ist eine Erfassung und Auswertung einer Serie von Messwerten über einen vorbestimmten Zeitraum und/oder zu vorbestimmten Zeitpunkten ermöglicht. Besonders günstig ist es dabei, wenn die Hinterlegung der Messwerte mit einer zugeordneten Zeitinformation ermöglicht ist. Somit ist eine Zuordnung zu anderen Ereignissen über die korrelierte Zeitinformation ermöglicht.

Bei einer Ausgestaltung der Erfindung ist vorgesehen, dass der erste metallische Wandbereich und der zweite metallische Wandbereich an separaten Gehäuseteilen ausgebildet sind. Somit ist auf einfache Weise eine galvanische Trennung zwischen dem ersten Pol und dem zweiten Pol einrichtbar, beispielsweise über ein noch genauer zu beschreibendes Kupplungsteil. Besonders günstig ist es dabei, wenn die Gehäuseteile metallisch ausgeführt sind. Es sind somit einfach hohe Dichtigkeitsklassen erreichbar. Alternativ oder zusätzlich kann vorgesehen sein, dass die Gehäuseteile als Metall-Kunststoff-Hybrid ausgeführt sind, wobei die metallischen Wandbereiche in einem Metallanteil der Gehäuseteile ausgebildet sein können. Die Fertigungskosten sind somit reduzierbar.

Bei einer Ausgestaltung der Erfindung ist vorgesehen, dass die Gehäuseteile über ein Kupplungsteil verbunden sind. Besonders günstig ist es dabei, wenn der Gehäuseteil mit dem ersten metallischen Wandbereich mit dem Kupplungsteil verbunden ist. Diese Verbindung kann unlösbar sein und/oder beispielsweise durch eine Schraubverbindung herstellbar. Alternativ oder zusätzlich kann vorgesehen sein, dass der Gehäuseteil mit dem zweiten metallischen Wandbereich mit dem Kupplungsteil verbunden ist. Somit ist eine stabile Befestigung und Abdichtung des Gehäuses beschrieben. Diese Verbindung kann unlösbar sein oder beispielsweise durch eine Schraubverbindung. Bevorzugt sind die unlösbaren Verbindungen stoffschlüssig, beispielsweise geklebt oder geschweißt, ausgeführt.

Bei einer Ausgestaltung der Erfindung ist vorgesehen, dass das Kupplungsteil mit wenigstens einem der Gehäuseteile eine Kupplung bildet. Somit ist eine einfache Montage und Demontage erreichbar. Bevorzugt ist die Kupplung unlösbar eingerichtet oder zumindest gegen ein unbeabsichtigtes Lösen gesichert. Besonders günstig ist es dabei, wenn das Kupplungsteil mit dem Gehäuseteil des ersten metallischen Wandbereichs verbunden ist. Somit ist dieses Gehäuseteil fest an dem Kupplungsteil haltbar, insbesondere zur Abdichtung nach außen. Alternativ oder zusätzlich kann vorgesehen sein, dass das Kupplungsteil mit dem Gehäuseteil des zweiten metallischen Wandbereichs verbunden ist. Somit ist dieses Gehäuseteil fest, insbesondere nach außen abdichtend, an dem Kupplungsteil oder sogar an dem Gehäuseteil des ersten Wandbereichs fixierbar. Es ist somit auf einfache Weise ein dichtes Gehäuse bereitstellbar.

Bei einer Ausgestaltung der Erfindung ist vorgesehen, dass das Kupplungsteil die elektrische Isolation des ersten Wandbereichs von dem zweiten Wandbereich bewirkt. Somit ist eine einfache galvanische Trennung insbesondere bei metallischen Gehäuseteilen erreichbar, insbesondere mit einem Kupplungsteil aus Kunststoff. Besonders günstig ist es dabei, wenn die elektrische Isolation durch einen um das Kupplungsteil umlaufenden, zwischen dem Gehäuseteil des ersten metallischen Wandbereichs und dem Gehäuseteil des zweiten metallischen Wandbereichs angeordneten Kragen bewirkt ist. Von Vorteil ist dabei, dass bei im Wesentlichen glatter Außenkontur des Gehäuses eine elektrische Trennung der metallischen Wandbereiche, insbesondere bei metallischen Gehäuseteilen, einrichtbar ist.

Bei einer Ausgestaltung der Erfindung ist vorgesehen, dass das Kupplungsteil eine Durchgangsöffnung aufweist, durch welche der erste Pol und/oder der zweite Pol mit der Sensorsignalverarbeitungseinrichtung elektrisch verbunden ist/sind. Somit ist eine einfache Kabelführung im Inneren des Datenloggers erreichbar. Zusätzlich ist die Montage einfach ausführbar, indem beispielsweise wenigstens ein bereits verdrahteter Pol durch die Durchgangsöffnung gesteckt wird.

Bei einer Ausgestaltung der Erfindung ist vorgesehen, dass der erste Pol und der zweite Pol auf einander gegenüber liegenden Seiten des Kupplungsteils ausgebildet sind. Somit ist eine räumliche Trennung der metallischen Wandbereiche auf die Pole übertragbar. Besonders günstig ist es hierbei, wenn wenigstens ein Pol in der beschriebenen Weise durch eine Durchgangsöffnung des Kupplungsteils zu der Signalverarbeitungseinrichtung geführt ist.

Bei einer Ausgestaltung der Erfindung ist vorgesehen, dass die Sensorsignalverarbeitungseinrichtung auf wenigstens einer Leiterplatte angeordnet ist, welche in oder an eine Durchgangsöffnung des Kupplungsteils, beispielsweise die bereits erwähnte Durchgangsöffnung, gesetzt ist. die Somit ist eine platzsparende Anordnung schaffbar. Die wenigstens eine Leiterplatte kann hierbei so dimensioniert sein, dass sie die Durchgangsöffnung verschließt. Besonders günstig ist es, wenn die Pole die wenigstens eine Leiterplatte zwischen sich aufnehmen.

Bei einer Ausgestaltung der Erfindung ist vorgesehen, dass die Sensorsignalverarbeitungseinrichtung auf wenigstens zwei Leiterplatten angeordnet ist, die durch ein Leiterband miteinander elektrisch verbunden sind. Somit ist eine größer Anzahl von Bauelementen innerhalb eines vorgegebenen Querschnitts des Datenloggers unterbringbar. Von Vorteil ist weiter, dass die Sensorsignalverarbeitungseinrichtung montierfertig außerhalb der bereits erwähnten Durchgangsöffnung herstellbar ist.

Bei einer Ausgestaltung der Erfindung ist vorgesehen, dass die Sensorsignalverarbeitungseinrichtung auf wenigstens drei Leiterplatten angeordnet ist, wobei zwei der wenigstens drei Leiterplatten als äußere Leiterplatten über jeweils ein Leiterband elektrisch mit einer dritten der wenigstens drei Leiterplatte als mittlere Leiterplatte verbunden sind. Somit sind die Leiterplatten platzsparend zusammenfaltbar und - beispielsweise zur Bestückung - auffaltbar. Besonders günstig ist es dabei, wenn die wenigstens drei Leiterplatten derart miteinander verbunden sind, dass die wenigstens drei Leiterplatten in einer gemeinsamen Ebene anordenbar sind. Dies erleichtert die Bestückung vor der Montage in an sich bekannten Herstellungsverfahren.

Bei einer Ausgestaltung der Erfindung ist vorgesehen, dass die wenigstens zwei Leiterplatten an dem Kupplungsteil in einer Stapelanordnung angeordnet sind. Hierbei kann eine Stapelanordnung von Leiterplatten beispielsweise dadurch charakterisiert werden, dass die Leiterplatten - beabstandet oder unmittelbar aneinander anliegend - übereinander angeordnet sind, sodass sich die einzelnen Leiterplatten zumindest teilweise überlappen. Eine Stapelanordnung ist besonders platzsparend. Besonders günstig ist es, wenn die wenigstens drei Leiterplatten in einer Stapelanordnung angeordnet sind.

Bei einer Ausgestaltung der Erfindung ist vorgesehen, dass der erste Pol und/oder der zweite Pol an einer Leiterplatte ausgebildet ist/sind. Besonders günstig ist es, wenn der erste Pol an einer anderen Leiterplatte der bereits erwähnten wenigstens zwei oder sogar wenigstens drei Leiterplatten als der zweite Pol ausgebildet ist. Dies ermöglicht beispielsweise eine einfache Kontaktierung in dem erwähnten zusammengefalteten Zustand. Bevorzugt ist bei der Ausgestaltung mit wenigstens drei Leiterplatten vorgesehen, dass die Pole jeweils an einer der beiden äußeren Leiterplatten ausgebildet sind. Somit sind die Pole auch im montierten Zustand einfach zugänglich.

Bei einer Ausgestaltung der Erfindung ist vorgesehen, dass zwischen dem ersten Pol und dem ersten metallischen Wandbereich ein metallisches Federelement angeordnet ist. Somit sind unterschiedliche Wärmeausdehnungskoeffizienten des ersten Wandbereichs einerseits und eines mit dem ersten Pol verbundenen Bauteils andererseits, beispielsweise aufgrund unterschiedlicher Materialien, ausgleichbar. Besonders günstig ist es dabei, wenn das Federelement lose eingelegt ist. Dies ermöglicht eine einfache Montage. Bevorzugt ist das Federelement ein Wellfederring. Ein Wellfederring hat sich für eine sichere Kontaktierung besonders bewährt.

Bei einer Ausgestaltung der Erfindung ist vorgesehen, dass zwischen dem zweiten Pol und dem zweiten metallischen Wandbereich ein metallisches Federelement angeordnet ist. Somit sind unterschiedliche Wärmeausdehnungskoeffizienten des zweiten Wandbereichs einerseits und eines mit dem zweiten Pol verbundenen Bauteils andererseits, beispielsweise aufgrund unterschiedlicher Materialien, ausgleichbar. Besonders günstig ist es dabei, wenn das Federelement lose eingelegt ist. Dies ermöglicht eine einfache Montage. Bevorzugt ist das Federelement ein Wellfederring. Besonders bevorzugt ist die Ausgestaltung mit der zuvor beschriebenen Ausgestaltung am ersten Pol kombiniert.

Bei einer Ausgestaltung der Erfindung ist vorgesehen, dass das Federelement des ersten Pols und/oder das Federelement des zweiten Pols (jeweils) an einer nach innen hervorstehenden Schulter des jeweiligen metallischen Wandbereichs abgestützt ist/sind. Somit ist ein einfaches Einlegen des (jeweiligen) Federelements, beispielsweise einer Wellfeder, erreichbar. Eine sichere Kontaktierung des jeweiligen metallischen Wandbereichs ist herstellbar.

Zur Lösung der genannten Aufgabe sind alternativ die Merkmale des unabhängigen, auf eine Verwendung gerichteten Anspruchs vorgesehen. Insbesondere wird somit erfindungsgemäß zur Lösung der genannten Aufgabe bei einer Verwendung vorgeschlagen, zwei metallische Wandbereichen eines Gehäuses eines Datenloggers, insbesondere eines Datenloggers nach einem der vorangehenden Ansprüche, zu einer elektrischen Übertragung von Daten durch das Gehäuse zu verwenden. Aufwendige elektrische Durchkontakierungen mit Steckern und dergleichen sind verzichtbar. Das Gehäuse ist somit im Wesentlichen oder ganz durchbrechungsfrei für die Datenübertragung nutzbar.

Besonders günstig ist es, wenn hierbei ein erfindungsgemäßer Logger, insbesondere wie zuvor beschrieben und/oder nach einem der auf einen Datenlogger gerichteten Ansprüche, verwendet wird. Somit sind die zu dem erfindungsgemäßen Datenlogger beschriebenen Vorteile nutzbar.

Bei einer Ausgestaltung der Erfindung ist vorgesehen, dass gespeicherte Messwerte von der Sensorsignalverarbeitungseinrichtung durch das Gehäuse nach außen übertragen werden. Somit ist ein typischer Anwendungsfall für einen Logger beschrieben. Die erfassten Messwerte sind auslesbar, ohne dass das Gehäuse geöffnet werden muss.

Alternativ oder zusätzlich kann vorgesehen sein, dass Konfigurationsdaten für die Sensorsignalverarbeitungseinrichtung durch das Gehäuse nach innen übertragen werden. Somit ist ein Öffnen des Gehäuses zu Wartungs- oder Konfigurationszwecken verzichtbar.

Die Erfindung wird nun anhand eines Ausführungsbeispiels näher beschrieben, ist jedoch nicht auf dieses Ausführungsbeispiel beschränkt. Weitere Ausführungsbeispiele ergeben sich durch Kombination der Merkmale einzelner oder mehrerer Ansprüche untereinander und/oder mit einzelnen oder mehreren Merkmalen des Ausführungsbeispiels.

Es zeigt in stark vereinfachter, schematisierter Form:
- Fig. 1: einen erfindungsgemäßen Datenlogger in einer Seitenansicht,
- Fig. 2: den Datenlogger aus Fig. 1 in einer Ansicht von vorn auf die Fühlerspitze,
- Fig. 3: den Datenlogger aus Fig. 1 in einer Schnittdarstellung entlang der Schnittlinie D-D aus Fig. 1,
- Fig. 4: den Datenlogger aus Fig. 1 in einer dreidimensionalen Schrägansicht von vorn in Explosionsdarstellung und
- Fig. 5: den Datenlogger aus Fig. 1 in einer dreidimensionalen Schrägansicht von hinten in Explosionsdarstellung.

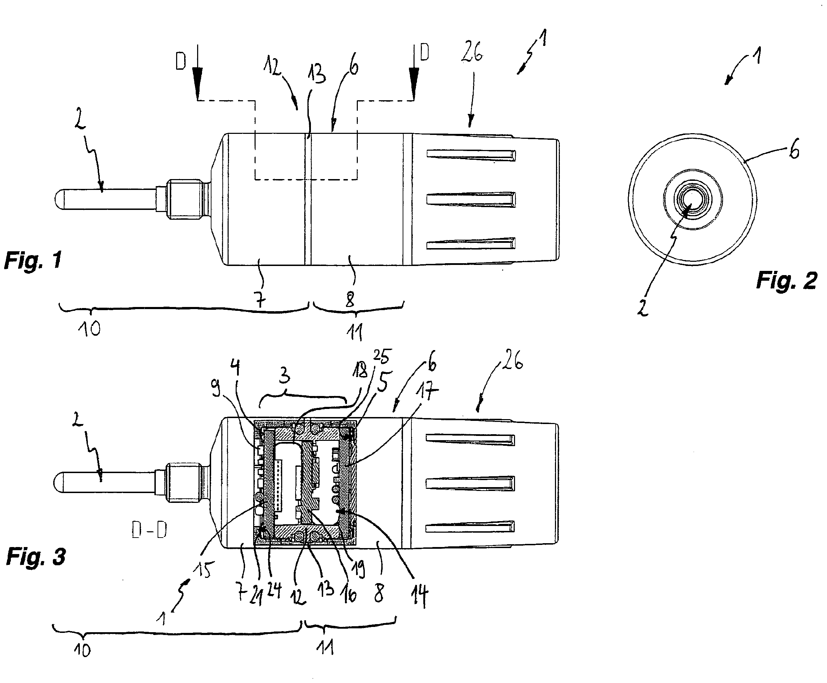

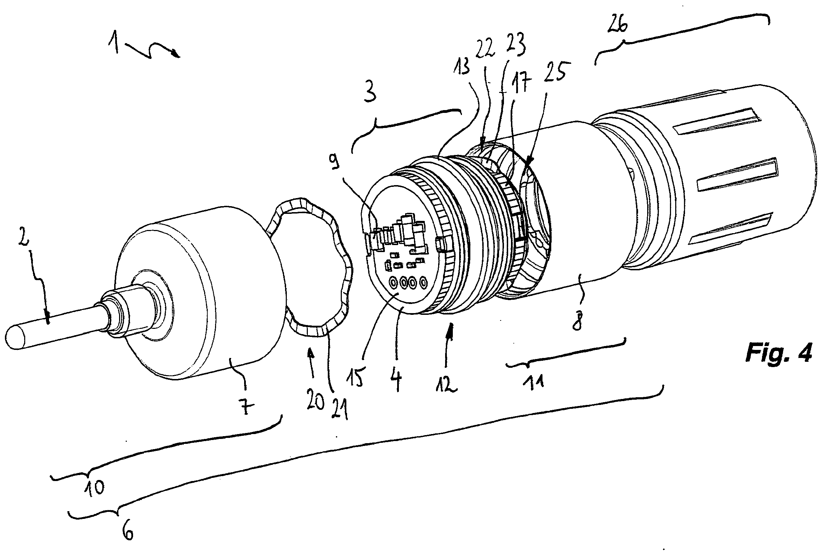

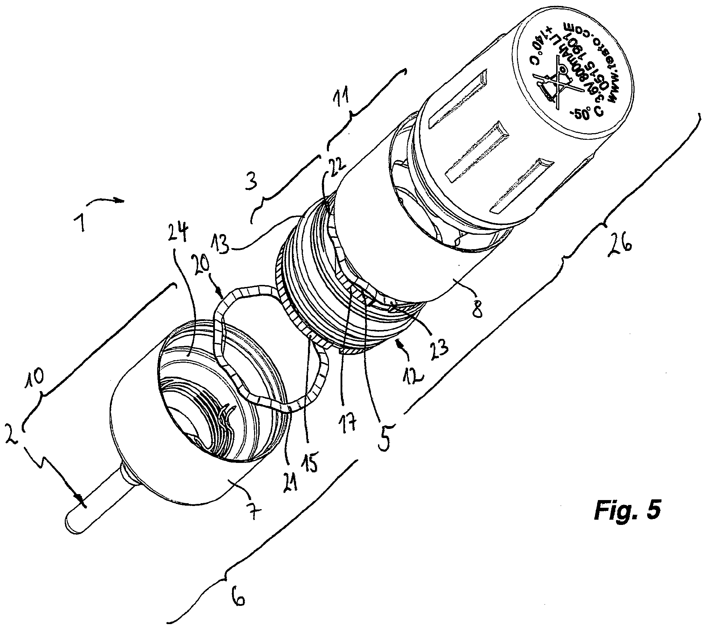

Die Figuren 1 bis 5 zeigen in unterschiedlichen Ansichten einen im Ganzen mit 1 bezeichneten erfindungsgemäßen Datenlogger.

Der Datenlogger 1 hat wenigstens einen Messsensor 2 und eine Sensorsignalverarbeitungseinrichtung 3. Der Messsensor 2 ist in an sich bekannter Weise an der Sensorsignalverarbeitungseinrichtung 3 angeschlossen, um eine Erfassung von Messwerten zu vorbestimmten Zeitpunkten und eine Hinterlegung der erfassten Messwerte in einem Speicher zu ermöglichen.

Die Sensorsignalverarbeitungseinrichtung 3 ist hierzu zu einer Verarbeitung des Sensorsignals des wenigstens einen Messsensors 2 eingerichtet.

An der Sensorsignalverarbeitungseinrichtung 3 ist ein Datenanschluss mit einem ersten Pol 4 und einem zweiten Pol 5 ausgebildet. Der Datenanschluss kann noch weitere Pole aufweisen, die hier nicht gezeigt sind. Die Sensorsignalverarbeitungseinrichtung 3 und der wenigstens eine Messsensor 2 sind durch ein Gehäuse 6 gekapselt und nach außen dicht abgeschlossen.

Das Gehäuse 6 weist einen ersten metallischen Wandbereich 7 und einen zweiten metallischen Wandbereich 8 auf, die jeweils für sich genommen eine elektrische Kontaktierung durch das Gehäuse 6 ermöglichen.

Der erste metallische Wandbereich 7 ist hierbei in noch genauer zu beschreibender Weise von dem zweiten metallischen Wandbereich 8 elektrisch isoliert.

Der erste Pol 4 kontaktiert den ersten metallischen Wandbereich 7 von innen in noch genauer zu beschreibender Weise. Der zweite Pol 5 kontaktiert den zweiten metallischen Wandbereich 8 in ähnlicher Weise elektrisch von innen.

Somit sind der erste Pol 4 und der zweite Pol 5 von außen elektrisch zugänglich.

Die Sensorsignalverarbeitungseinrichtung 3 ist mit einem Speicher 9 elektrisch verbunden, der zu einer elektronischen Hinterlegung des verarbeiteten Sensorsignals mit einer zugeordneten Zeitinformation, also der zeitkorrelierten Messwerte, an die Sensorsignalverarbeitungseinrichtung 3 angeschlossen ist.

Der erste metallische Wandbereich 7 ist im Ausführungsbeispiel als Teil eines einstückigen metallischen Gehäuseteils 10 ausgebildet. Ebenso ist der zweite metallische Wandbereich 8 als Teil eines ebenfalls einstückigen metallischen Gehäuseteils 11 ausgebildet. Die Gehäuseteile 10, 11 sind hierbei über ein Kupplungsteil 12 miteinander verbunden. Das Kupplungsteil 12 bewirkt hierbei die elektrische Isolation der Wandbereiche 7, 8 voneinander, indem es einen um das Kupplungsteil 12 umlaufenden Kragen 13 bildet. Der Kragen 13 ist im montierten Zustand zwischen den Gehäuseteilen 10, 11 angeordnet und trennt diese somit elektrisch voneinander.

In dem Kupplungsteil 12 ist eine durchgehende Durchgangsöffnung 14 ausgebildet, durch welche der erste Pol 4 und der zweite Pol 5 elektrisch mit der Sensorsignalverarbeitungseinrichtung 3 verbunden sind. Der erste Pol 4 und der zweite Pol 5 liegen hierbei auf einander gegenüberliegenden Seiten des Kupplungsteils 12.

Die Sensorsignalverarbeitungseinrichtung 3 ist auf drei Leiterplatten 15, 16, 17 verteilt, die in die Durchgangsöffnung 14 des Kupplungsteils 12 eingesetzt sind.

Hierbei sind die äußeren Leiterplatten 15, 17 mit der mittleren Leiterplatte 16 jeweils über ein flexibles Leiterband 18, 19 elektrisch verbunden. Die flexiblen Leiterbänder 18, 19 sind derart an einander gegenüberliegenden Seiten der mittleren Leiterplatte 16 und an korrespondierenden Seiten der äußeren Leiterplatten 15, 17 angeordnet, dass die drei Leiterplatten 15, 16, 17 in einer gemeinsamen Ebene angeordnet werden können.

In eingesetztem Zustand bilden die Leiterplatten 15, 16, 17 an dem Kupplungsteil 12 eine Stapelanordnung.

Zwischen dem ersten Pol 4 und dem zugehörigen ersten metallischen Wandbereich 7 ist ein metallisches Federelement 20 in Form einer Wellfeder 21 angeordnet. Gleichermaßen ist zwischen dem zweiten Pol 5 und dem zugehörigen zweiten metallischen Wandbereich 8 ein Federelement 22 in Form einer Wellfeder 23 ausgebildet. Die Federelemente 20, 22 sind hierbei lose an dem Kupplungsteil 12 und lose an den Gehäuseteilen 10, 11 angelegt.

Im Inneren der Gehäuseteile 10, 11 ist jeweils eine Schulter 24, 25 ausgebildet, an welcher das jeweilige Federelement 20, 22 anliegt.

In Betrieb werden somit die metallischen Wandbereiche 7, 8 zur Kontaktierung der Pole 4, 5 von außen, ohne dass das Gehäuse 6 geöffnet werden muss, verwendet.

Hierbei können beispielsweise gespeicherte Messwerte aus dem Speicher 9 ausgelesen und/oder Konfigurationsdaten für die Sensorsignalverarbeitungseinrichtung 3 durch das Gehäuse 6 nach innen übertragen werden.

Ein Batterieteil 26 ist mit dem Gehäuse 6 lösbar verbunden.

Bei dem Datenlogger 1 wird vorgeschlagen, an einem Gehäuse 6 zwei voneinander elektrisch getrennte metallische Wandbereiche 7, 8 auszubilden, durch welche ein Datenanschluss, der zumindest einen ersten Pol 4 und einen zweiten Pol 5 aufweist, von außen elektrisch zu kontaktieren.

### Bezugszeichenliste

- 1: Datenlogger
- 2: Messsensor
- 3: Sensorsignalverarbeitungseinrichtung
- 4: erster Pol
- 5: zweiter Pol
- 6: Gehäuse
- 7: erster metallischer Wandbereich
- 8: zweiter metallischer Wandbereich
- 9: Speicher
- 10: Gehäuseteil
- 11: Gehäuseteil
- 12: Kupplungsteil
- 13: Kragen
- 14: Durchgangsöffnung
- 15: (äußere) Leiterplatte
- 16: (mittlere) Leiterplatte
- 17: (äußere) Leiterplatte
- 18: flexibles Leiterband
- 19: flexibles Leiterband
- 20: metallisches Federelement
- 21: Wellfeder
- 22: metallisches Federelement
- 23: Wellfeder
- 24: Schulter
- 25: Schulter
- 26: Batterieteil

## Patentansprüche

1. Datenlogger (1), mit wenigstens einen Messsensor (2), einer Sensorsignalverarbeitungseinrichtung (3), die zu einer Verarbeitung eines Sensorsignals des wenigstens einen Messsensors (2) eingerichtet ist, wobei an der Sensorsignalverarbeitungseinrichtung (3) ein Datenanschluss mit einem ersten Pol (4) und einem zweiten Pol (5) ausgebildet ist, und einem Gehäuse (6), in welchem die Sensorsignalverarbeitungseinrichtung (3) angeordnet sind, wobei das Gehäuse (6) nach außen dicht ausgebildet ist, **dadurch gekennzeichnet, dass** das Gehäuse (6) einen ersten metallischen Wandbereich (7) und einen zweiten metallischen Wandbereich (8) aufweist, dass der erste metallische Wandbereich (7) und der zweite metallische Wandbereich (8) voneinander elektrisch isoliert und jeweils von außen zugänglich sind und dass der erste Pol (4) den ersten metallischen Wandbereich (7) von innen elektrisch kontaktiert und der zweite Pol (5) den zweiten metallischen Wandbereich (8) elektrisch kontaktiert.

2. Datenlogger (1) nach Anspruch 1, **dadurch gekennzeichnet, dass** ein Speicher (9) zu einer elektronischen Hinterlegung des verarbeiteten Sensorsignals, vorzugsweise mit einer zugeordneten Zeitinformation, an die Sensorsignalverarbeitungseinrichtung (3) angeschlossen ist.

3. Datenlogger (1) nach einem der vorangehenden Ansprüche, **dadurch gekennzeichnet, dass** der erste metallische Wandbereich (7) und der zweite metallische Wandbereich (8) an separaten, vorzugsweise metallischen oder als Metall-Kunststoff-Hybrid ausgeführten Gehäuseteilen (10, 11) ausgebildet sind.

4. Datenlogger (1) nach einem der vorangehenden Ansprüche, **dadurch gekennzeichnet, dass** die Gehäuseteile (10, 11) über ein Kupplungsteil (12) verbunden sind, insbesondere wobei der Gehäuseteil (10) mit dem ersten metallischen Wandbereich (7) insbesondere unlösbar, vorzugsweise stoffschlüssig, und/oder über eine Schraubverbindung mit dem Kupplungsteil (12) verbunden ist und/oder wobei der Gehäuseteil (11) mit dem zweiten metallischen Wandbereich (8) insbesondere unlösbar, vorzugsweise stoffschlüssig, und/oder über eine Schraubverbindung mit dem Kupplungsteil (12) verbunden ist.

5. Datenlogger (1) nach einem der vorangehenden Ansprüche, **dadurch gekennzeichnet, dass** das Kupplungsteil (12) die elektrische Isolation des ersten Wandbereichs (7) von dem zweiten Wandbereich (8) bewirkt, insbesondere durch einen um das Kupplungsteil (12) umlaufenden, zwischen dem Gehäuseteil (10) des ersten metallischen Wandbereichs (7) und dem Gehäuseteil (11) des zweiten metallischen Wandbereichs (8) angeordneten Kragen (13).

6. Datenlogger (1) nach einem der vorangehenden Ansprüche, **dadurch gekennzeichnet, dass** das Kupplungsteil (12) eine Durchgangsöffnung (14) aufweist, durch welche der erste Pol (4) und/oder der zweite Pol (5) mit der Sensorsignalverarbeitungseinrichtung (3) elektrisch verbunden ist/sind, und/oder dass der erste Pol (4) und der zweite Pol (5) auf einander gegenüber liegenden Seiten des Kupplungsteils (12) ausgebildet sind.

7. Datenlogger (1) nach einem der vorangehenden Ansprüche, **dadurch gekennzeichnet, dass** die Sensorsignalverarbeitungseinrichtung (3) auf wenigstens einer Leiterplatte (15, 16, 17) angeordnet ist, welche in oder an die oder eine Durchgangsöffnung (14) des Kupplungsteils (12) gesetzt ist.

8. Datenlogger (1) nach einem der vorangehenden Ansprüche, **dadurch gekennzeichnet, dass** die Sensorsignalverarbeitungseinrichtung (3) auf wenigstens zwei Leiterplatten (15, 16, 17) angeordnet ist, die durch ein Leiterband (18) miteinander elektrisch verbunden sind und/oder dass die Sensorsignalverarbeitungseinrichtung (3) auf wenigstens drei Leiterplatten (15, 16, 17) angeordnet ist, wobei zwei der wenigstens drei Leiterplatten (15, 16, 17) als äußere Leiterplatten (15, 17) über jeweils ein Leiterband (18, 19) elektrisch mit einer dritten der wenigstens drei Leiterplatten (15, 16, 17) als mittlere Leiterplatte (16) verbunden sind, insbesondere derart, dass die wenigstens drei Leiterplatten (15, 16, 17) in einer gemeinsamen Ebene anordenbar sind.

9. Datenlogger (1) nach einem der vorangehenden Ansprüche, **dadurch gekennzeichnet, dass** die wenigstens zwei, insbesondere die wenigstens drei, Leiterplatten (15, 16, 17) an dem Kupplungsteil (12) in einer Stapelanordnung angeordnet sind.

10. Datenlogger (1) nach einem der vorangehenden Ansprüche, **dadurch gekennzeichnet, dass** der erste Pol (4) und/oder der zweite Pol (5) an einer Leiterplatte (15, 16, 17), insbesondere einer der wenigstens zwei oder drei Leiterplatten (15, 16, 17), ausgebildet ist/sind und/oder dass zwischen dem ersten Pol (4) und dem ersten metallischen Wandbereich (7) ein metallisches Federelement (20), vorzugsweise ein Wellfederring (21), angeordnet, insbesondere lose eingelegt, ist und/oder zwischen dem zweiten Pol (5) und dem zweiten metallischen Wandbereich (8) ein metallisches Federelement (22), vorzugsweise ein Wellfederring (23), angeordnet, insbesondere lose eingelegt, ist.

11. Datenlogger (1) nach einem der vorangehenden Ansprüche, **dadurch gekennzeichnet, dass** das Federelement (20) des ersten Pols (4) und/oder das Federelement (22) des zweiten Pols (5) an einer nach innen hervorstehenden Schulter (24, 25) des jeweiligen metallischen Wandbereichs (7, 8) abgestützt ist.

12. Verwendung von zwei metallischen Wandbereichen (7, 8) eines Gehäuses (6) eines Datenloggers (1) nach einem der vorangehenden Ansprüche zu einer elektrischen Übertragung von Daten durch das Gehäuse (6).

13. Verwendung nach Anspruch 12, **dadurch gekennzeichnet, dass** gespeicherte Messwerte von der Signalverarbeitungseinrichtung (3) durch das Gehäuse (6) nach außen und/oder Konfigurationsdaten für die Signalverarbeitungseinrichtung (3) durch das Gehäuse (6) nach innen übertragen werden.

## Claims

1. Data logger (1), comprising at least a measurement sensor (2), a sensor signal processing device (3) which is designed to process a sensor signal of the at least one measurement sensor (2), with a data connection comprising a first pole (4) and a second pole (5) being formed on the sensor signal processing device (3), and a housing (6) in which the sensor signal processing device (3) are arranged, with the housing (6) being designed such that it is sealed to the outside, **characterized in that** the housing (6) has a first metal wall region (7) and a second metal wall region (8), **in that** the first metal wall region (7) and the second metal wall region (8) are electrically insulated from one another and are each accessible from the outside, and **in that** the first pole (4) makes electrical contact with the first metal wall region (7) from the inside and the second pole (5) makes electrical contact with the second metal wall region (8).

2. Data logger (1) according to Claim 1, **characterized in that** a memory (9) for electronically storing the processed sensor signal, preferably with an associated item of time information, is connected to the sensor signal processing device (3).

3. Data logger (1) according to either of the preceding claims, **characterized in that** the first metal wall region (7) and the second metal wall region (8) are formed on separate, preferably metal or metal/plastic hybrid housing parts (10, 11).

4. Data logger (1) according to one of the preceding claims, **characterized in that** the housing parts (10, 11) are connected by means of a coupling part (12), in particular with the housing part (10), by way of the first metal wall region (7), being connected to the coupling part (12) in particular in a non-detachable manner, preferably in a cohesive manner, and/or by means of a screw connection, and/or with the housing part (11), by way of the second metal wall region (8), being connected to the coupling part (12) in particular in a non-detachable manner, preferably in a cohesive manner, and/or by means of a screw connection.

5. Data logger (1) according to one of the preceding claims, **characterized in that** the coupling part (12) electrically insulates the first wall region (7) from the second wall region (8), in particular by a collar (13) which surrounds the coupling part (12) and is arranged between the housing part (10) of the first metal wall region (7) and the housing part (11) of the second metal wall region (8).

6. Data logger (1) according to one of the preceding claims, **characterized in that** the coupling part (12) has a passage opening (14) through which the first pole (4) and/or the second pole (5) are/is electrically connected to the sensor signal processing device (3), and/or **in that** the first pole (4) and the second pole (5) are formed on opposite sides of the coupling part (12) .

7. Data logger (1) according to one of the preceding claims, **characterized in that** the sensor signal processing device (3) is arranged on at least one printed circuit board (15, 16, 17) which is placed in or on the or a passage opening (14) of the coupling part (12).

8. Data logger (1) according to one of the preceding claims, **characterized in that** the sensor signal processing device (3) is arranged on at least two printed circuit boards (15, 16, 17) which are electrically connected to one another by a conductor strip (18), and/or **in that** the sensor signal processing device (3) is arranged on at least three printed circuit boards (15, 16, 17), wherein two of the at least three printed circuit boards (15, 16, 17), as outer printed circuit boards (15, 17), are electrically connected to a third of the at least three printed circuit boards (15, 16, 17), as middle printed circuit board (16), by means of a respective conductor strip (18, 19), in particular in such a way that the at least three printed circuit boards (15, 16, 17) can be arranged in a common plane.

9. Data logger (1) according to one of the preceding claims, **characterized in that** the at least two, in particular the at least three, printed circuit boards (15, 16, 17) are arranged on the coupling part (12) in a stacked arrangement.

10. Data logger (1) according to one of the preceding claims, **characterized in that** the first pole (4) and/or the second pole (5) are/is arranged on one printed circuit board (15, 16, 17), in particular one of the at least two or three printed circuit boards (15, 16, 17), and/or **in that** a metal spring element (20), preferably a corrugated spring ring (21) is arranged, in particular loosely inserted, between the first pole (4) and the first metal wall region (7), and/or a metal spring element (22), preferably a corrugated spring ring (23), is arranged, in particular loosely inserted, between the second pole (5) and the second metal wall region (8).

11. Data logger (1) according to one of the preceding claims, **characterized in that** the spring element (20) of the first pole (4) and/or the spring element (22) of the second pole (5) are/is supported on an inwardly projecting shoulder (24, 25) of the respective metal wall region (7, 8).

12. Use of two metal wall regions (7, 8) of a housing (6) of a data logger (1) according to one of the preceding claims for electrically transmitting data through the housing (6).

13. Use according to Claim 12, **characterized in that** stored measurement values are transmitted from the signal processing device (3), through the housing (6), to the outside, and/or configuration data for the signal processing device (3) is transmitted through the housing (6) to the inside.

## Revendications

1. Enregistreur de données (1), avec au moins un capteur de mesure (2), un dispositif de traitement des signaux de capteur (3), qui est configuré pour un traitement d'un signal de capteur dudit au moins un capteur de mesure (2), dans lequel un port de données avec un premier pôle (4) et un second pôle (5) est formé sur le dispositif de traitement des signaux de capteur (3), et avec un boîtier (6), dans lequel le dispositif de traitement des signaux de capteur (3) est disposé, dans lequel le boîtier (6) est étanche vers l'extérieur, **caractérisé en ce que** le boîtier (6) présente une première zone de paroi métallique (7) et une seconde zone de paroi métallique (8), **en ce que** la première zone de paroi métallique (7) et la seconde zone de paroi métallique (8) sont électriquement isolées l'une de l'autre et sont chacune accessibles de l'extérieur et **en ce que** le premier pôle (4) est en contact électrique par l'intérieur avec la première zone de paroi métallique (7) et le second pôle (5) est en contact électrique avec la seconde zone de paroi métallique (8).

2. Enregistreur de données (1) selon la revendication 1, **caractérisé en ce qu'**une mémoire (9) destinée au stockage électronique du signal de capteur traité, est raccordée au dispositif de traitement des signaux de capteur (3), de préférence avec une information de temps associée.

3. Enregistreur de données (1) selon l'une quelconque des revendications précédentes, **caractérisé en ce que** la première zone de paroi métallique (7) et la seconde zone de paroi métallique (8) sont formées sur des parties de boîtier séparées (10, 11), de préférence métalliques ou réalisées sous forme hybride métal-plastique.

4. Enregistreur de données (1) selon l'une quelconque des revendications précédentes, **caractérisé en ce que** les parties de boîtier (10, 11) sont assemblées par une partie de couplage (12), en particulier dans lequel la partie de boîtier (10) avec la première zone de paroi métallique (7) est assemblée à la partie de couplage (12), en particulier de façon inséparable, de préférence par une liaison matérielle et/ou par un assemblage vissé et/ou dans lequel la partie de boîtier (11) avec la seconde zone de paroi métallique (8) est assemblée à la partie de couplage (12), en particulier de façon inséparable, de préférence par une liaison matérielle et/ou par un assemblage vissé.

5. Enregistreur de données (1) selon l'une quelconque des revendications précédentes, **caractérisé en ce que** la partie de couplage (12) assure l'isolation électrique de la première zone de paroi (7) par rapport à la seconde zone de paroi (8), en particulier par un rebord (13) entourant la partie de couplage (12) entre la partie de boîtier (10) de la première zone de paroi métallique (7) et la partie de boîtier (11) de la seconde zone de paroi métallique (8).

6. Enregistreur de données (1) selon l'une quelconque des revendications précédentes, **caractérisé en ce que** la partie de couplage (12) présente une ouverture de passage (14), à travers laquelle le premier pôle (4) et/ou le second pôle (5) sont reliés électriquement au dispositif de traitement des signaux de capteur (3) et/ou **en ce que** le premier pôle (4) et le second pôle (5) sont formés sur des côtés opposés l'un à l'autre de la partie de couplage (12).

7. Enregistreur de données (1) selon l'une quelconque des revendications précédentes, **caractérisé en ce que** le dispositif de traitement des signaux de capteur (3) est disposé sur au moins une plaquette de circuits imprimés (15, 16, 17), qui est placée dans ou sur la ou une ouverture de passage (14) de la partie de couplage (12).

8. Enregistreur de données (1) selon l'une quelconque des revendications précédentes, **caractérisé en ce que** le dispositif de traitement des signaux de capteur (3) est disposé sur au moins deux plaquettes de circuits imprimés (15, 16, 17), qui sont électriquement reliées l'une à l'autre par une bande conductrice (18) et/ou **en ce que** le dispositif de traitement des signaux de capteur (3) est disposé sur au moins trois plaquettes de circuits imprimés (15, 16, 17), dans lequel deux desdites au moins trois plaquettes de circuits imprimés (15, 16, 17) sont reliées électriquement en tant que plaquettes de circuits imprimés extérieures (15, 17) respectivement par une bande conductrice (18, 19) à une troisième desdites au moins trois plaquettes de circuits imprimés (15, 16, 17) en tant que plaquette de circuits imprimés intermédiaire (16), en particulier de telle manière que lesdites au moins trois plaquettes de circuits imprimés (15, 16, 17) puissent être disposées dans un plan commun.

9. Enregistreur de données (1) selon l'une quelconque des revendications précédentes, **caractérisé en ce que** lesdites au moins deux, en particulier lesdites au moins trois, plaquettes de circuits imprimés (15, 16, 17) sont disposées selon un agencement empilé sur la partie de couplage (12).

10. Enregistreur de données (1) selon l'une quelconque des revendications précédentes, **caractérisé en ce que** le premier pôle (4) et/ou le second pôle (5) est/sont formé(s) sur une plaquette de circuits imprimés (15, 16, 17), en particulier une desdites au moins trois plaquettes de circuits imprimés (15, 16, 17), et/ou **en ce qu'**un élément de ressort métallique (20), de préférence une rondelle élastique ondulée (21), est disposé, en particulier est inséré librement, entre le premier pôle (4) et la première zone de paroi métallique (7) et/ou un élément de ressort métallique (22), de préférence une rondelle élastique ondulée (23), est disposé, en particulier inséré librement, entre le second pôle (5) et la seconde zone de paroi métallique (8).

11. Enregistreur de données (1) selon l'une quelconque des revendications précédentes, **caractérisé en ce que** l'élément de ressort (20) du premier pôle (4) et/ou l'élément de ressort (22) du second pôle (5) est appuyé sur un épaulement saillant vers l'intérieur (24, 25) de la zone de paroi métallique respective (7, 8).

12. Utilisation de deux zones de parois métalliques (7, 8) d'un boîtier (6) d'un enregistreur de données (1) selon l'une quelconque des revendications précédentes en vue d'une transmission électrique de données par le boîtier (6).

13. Utilisation selon la revendication 12, **caractérisée en ce que** des valeurs de mesure mémorisées sont transmises du dispositif de traitement des signaux de capteur (3) vers l'extérieur par le boîtier (6) et/ou des données de configuration pour le dispositif de traitement des signaux de capteur (3) sont transmises vers l'intérieur par le boîtier (6).
